(19) Europäisches Patentamt

European Patent Office

Office européen des brevets

(11) **EP 0 859 963 B1**

(12) **FASCICULE DE BREVET EUROPEEN**

(45) Date de publication et mention
de la délivrance du brevet:
**29.09.1999 Bulletin 1999/39**

(21) Numéro de dépôt: **96938265.4**

(22) Date de dépôt: **06.11.1996**

(51) Int Cl.6: **G01R 31/36**

(86) Numéro de dépôt international:
**PCT/FR96/01748**

(87) Numéro de publication internationale:
**WO 97/17620 (15.05.1997 Gazette 1997/21)**

(54) **PROCEDE POUR DETERMINER L'ETAT DE CHARGE D'UNE BATTERIE D'ACCUMULATEURS**

VERFAHREN ZUR BESTIMMUNG DES LADEZUSTANDS EINES AKKUMULATORS

METHOD FOR DETERMINING THE CHARGE STATUS OF A STORAGE BATTERY

(84) Etats contractants désignés:
**DE ES GB IT**

(30) Priorité: **06.11.1995 FR 9513294**

(43) Date de publication de la demande:
**26.08.1998 Bulletin 1998/35**

(73) Titulaire: **RENAULT**
**92109 Boulogne-Billancourt (FR)**

(72) Inventeurs:
• **BUCHEL, Jean-Pierre**
**F-91090 Lisses (FR)**
• **BOGEL, Wolfang**
**F-75014 Paris (FR)**
• **ZANINOTTO, Franck**
**F-91210 Draveil (FR)**

(56) Documents cités:
**EP-A- 0 519 460      EP-A- 0 637 754**
**WO-A-90/13823      WO-A-93/15412**
**AU-A- 545 765       DE-A- 3 736 481**

## Description

La présente invention concerne les batteries d'accumulateurs électrochimiques, comme par exemple les batteries au plomb.

Le document WO-A-9013823 décrit un procédé comprenant des valeurs calculées et des valeurs estimées.

Plus particulièrement, la présente invention concerne un procédé pour déterminer l'état de charge d'une batterie d'accumulateurs pendant son utilisation, et une application d'un tel procédé à une batterie d'accumulateurs d'un véhicule automobile électrique.

Dans un véhicule automobile électrique, c'est-à-dire un véhicule équipé d'un moteur de traction électrique alimenté par une batterie d'accumulateurs, il est particulièrement important que le conducteur puisse être informé à chaque instant de l'état de charge de la batterie puisque de celle-ci dépend l'autonomie du véhicule. Cette information peut être donnée au conducteur sous forme de "charge restant dans la batterie", de "profondeur de décharge de la batterie", ou encore de "kilomètres pouvant encore être parcourus" si la consommation moyenne du véhicule est connue.

Quelque soit le mode de présentation de l'information au conducteur, il est avant tout nécessaire de disposer d'un procédé précis et fiable permettant de déterminer l'état de charge de la batterie. Par "précis", on désigne le fait de pouvoir obtenir des valeurs détaillées sur l'état de charge de la batterie (par exemple au pour-cent près), et par "fiable" le fait que toute confiance puisse être portée au résultat obtenu, qui doit être représentatif de la charge réelle encore disponible dans la batterie afin de ne pas induire le conducteur en erreur.

A ce jour, on connaît diverses méthodes de détermination de la charge d'une batterie, parmi lesquelles on distingue des méthodes coulométriques, basées sur une mesure de la quantité d'électricité débitée par la batterie une quantité d'électricité étant exprimée en coulombs ou en ampères-heures), et des méthodes estimatives, consistant à évaluer l'état de charge de la batterie à partir d'une mesure de la tension aux bornes de la batterie et du courant la traversant.

Ces méthodes comportent chacune des avantages et des inconvénients. Elles seront maintenant décrites et analysées car on y trouvera les fondements de la présente invention.

## Méthodes coulométriques classiques

Essentiellement, une méthode coulométrique consiste à faire le décompte des quantités d'électricité délivrées par la batterie afin de suivre l'évolution de sa charge électrique. Ce décompte est effectué en référence à une valeur nominale de charge Cref qui représente la quantité d'électricité optimale que peut débiter la batterie lorsqu'elle fonctionne selon un régime de décharge de référence réalisé avec des impulsions de courant calibrées en durée et en intensité et présentant un gabarit (ou profil d'impulsion) déterminé, et dans des conditions climatiques déterminées (température, etc.).

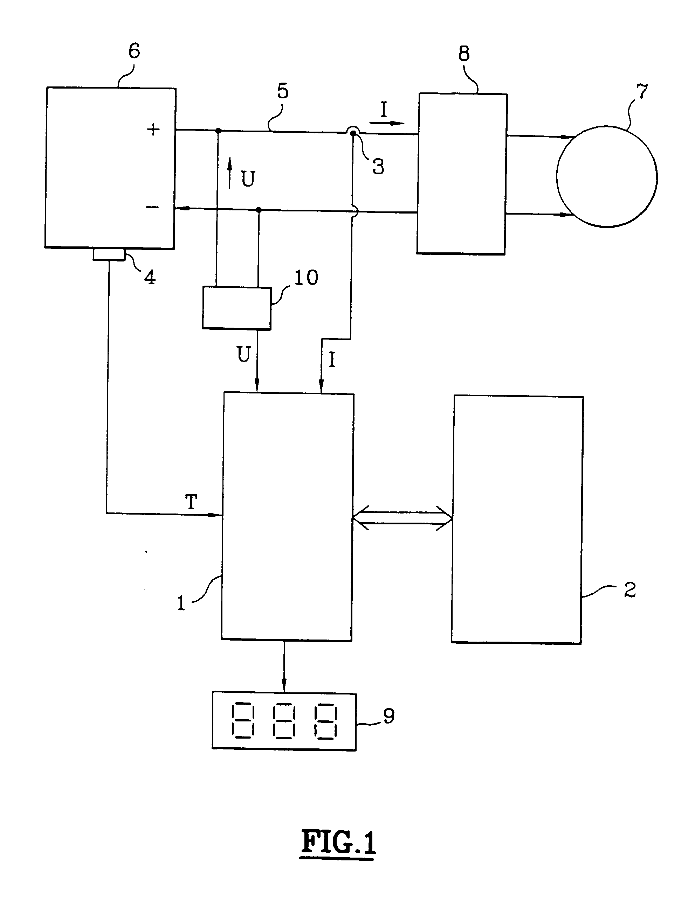

Une telle méthode est mise en oeuvre comme illustré en figure 1, au moyen d'un microprocesseur 1 équipé d'une mémoire programme 2, d'un capteur de courant 3 et d'un capteur de température 4, le capteur de courant 3 étant disposé dans une ligne d'alimentation 5 reliant une batterie 6 à surveiller à un dispositif à alimenter en énergie électrique, par exemple un moteur 7, le capteur de température 4 étant accolé à la batterie 6. Dans le cas où le moteur 7 est un moteur à courant alternatif, on trouve entre la batterie 6 et le moteur 7 un onduleur 8. Enfin, un afficheur 9 permet de présenter à un utilisateur la valeur de charge calculée.

Un cycle de décharge de la batterie, c'est-à-dire un cycle complet d'utilisation entre deux rechargements de la batterie, est décomposé par le microprocesseur 1 en une succession de microcycles de décharge se suivant sans interruption.

A chaque microcycle, le microprocesseur 1 mesure le courant moyen I traversant la batterie et en déduit la quantité d'électricité $Q_i$ débitée par la batterie 5 selon la relation suivante :

$$(1) \qquad Q_i = I\, \Delta t$$

$\Delta t$ étant la durée de chaque microcycle, choisie généralement de quelques dixièmes ou centièmes de seconde, "i" étant un indice représentant le rang du microcycle considéré.

Le microprocesseur 1 applique ensuite à la quantité d'électricité débitée $Q_i$ un coefficient de rendement $K_j$ choisi parmi une pluralité de coefficients $K_1, K_2, K_3, .... K_n$ prédéterminés expérimentalement et stockés dans la mémoire programme 2, et en déduit la charge électrique $\Delta C_i$ perdue par la batterie relativement à son régime de décharge de référence :

EP 0 859 963 B1

$$(2) \qquad \Delta C_i = K_j\, Q_i$$

Le microprocesseur 1 calcule ensuite la charge $C_i$ restant dans la batterie de la façon suivante :

$$(3) \qquad C_i = C_{i-1} - \Delta C_i$$

$C_{i-1}$ étant la charge calculée par le microprocesseur 1 à la fin du microcycle précédent, de rang n-1.

La relation (3) étant itérative, elle peut aussi s'écrire :

$$(4) \qquad C_i = Cref - \Sigma\, \Delta C_i$$

ou :

$$(5) \qquad C_i = Cref - \Sigma\, K_j\, Q_i$$

en supposant qu'au premier microcycle la batterie était chargée à son maximum Cref.

Ainsi, la charge calculée $C_i$ lors d'un microcycle donné est égale à la charge initiale Cref à laquelle on retranche la somme de toutes les quantités d'électricité fournies $Q_i$ corrigées par un coefficient de rendement $K_j$.

La profondeur de décharge PDD de la batterie, qui est le rapport de proportionnalité entre l'état de charge $C_i$ de la batterie et sa valeur nominale Cref, peut ensuite être calculée par le microprocesseur 1 :

$$(6) \qquad PDD = 100[(Cref - C_i)\,/Cref]\,\%$$

PDD étant exprimée ici en pourcentage.

Avec une telle méthode, et comme cela ressort clairement de la relation (5), la fiabilité du résultat obtenu dépend entièrement de la fiabilité des coefficients de rendement $K_j$. Or, les coefficients $K_j$ qui caractérisent les fluctuations du rendement de la batterie par rapport au régime de décharge de référence, dépendent de nombreux paramètres comme le courant délivré, la profondeur de décharge de la batterie, la température de la batterie, son vieillissement, etc. Par exemple, dans une batterie d'accumulateurs au plomb, une forte intensité de courant entraîne un appauvrissement de l'électrolyte $H_2SO_4$ (acide sulfurique) autour des électrodes des accumulateurs et une agglomération de cristaux de plomb $PbSO_4$ sur ces électrodes, ce qui conduit à une diminution du rendement. Une quantité d'électricité $Q_i$ fournie dans un temps bref et avec un fort courant va ainsi provoquer dans la batterie une perte de charge électrique $\Delta C_i$ plus importante que la même quantité d'électricité $Q_i$ fournie en un temps long et avec un faible courant. Il en est de même lorsque la profondeur de décharge PDD augmente, l'augmentation de la profondeur de décharge allant de pair avec une augmentation des cristaux $PbSO_4$ sur les électrodes et un appauvrissement de l'électrolyte $H_2SO_4$ (qui a été consommé). Egalement, une baisse de la température agit sur la formation des cristaux en augmentant leur solidité, et diminue le rendement. De nombreux autres paramètres influencent le rendement, comme l'âge de la batterie, les profils du courant imposé à la batterie, les temps de relaxation de l'électrolyte entre deux pointes de courant (par exemple lors d'une accélération), etc.

En pratique, il est clair que l'on ne peut pas prévoir une infinité de coefficients $K_j$ tenant compte de tous ces paramètres et de toutes les combinaisons possibles des valeurs de ces paramètres. C'est pourquoi on se contente généralement de définir des coefficients $K_j$ du type :

$$(7) \qquad K_j = f(I,\ PDD,\ T)$$

c'est-à-dire fonction uniquement du courant I, de la profondeur de décharge PDD et de la température T. Ainsi, à chaque microcycle, le microprocesseur 1 choisit le coefficient adéquat $K_j$ parmi l'ensemble des coefficients $K_1$ à $K_n$ disponibles, en fonction des valeurs que présentent les trois paramètres I, PDD, T,.

Malgré cette simplification, les méthodes coulométriques restent complexes à mettre en oeuvre pour un résultat qui s'avère finalement peu fiable, surtout lorsque l'on approche les · profondeurs de décharge importantes (au delà des 50%).

Toutefois, les méthodes coulométriques offrent une bonne précision, puisque microcycle après microcycle d'infimes variations de la charge peuvent être mesurées. **Méthodes classiques de détermination de la charge par estimation**

Comme cela est bien connu de l'homme de l'art, il existe dans une batterie d'accumulateurs un lien entre la profondeur de décharge PDD, la tension U aux bornes de la batterie et le courant I délivré. Ainsi, on peut établir expérimentalement un ensemble de courbes caractérisant la batterie, dites courbes de polarisation, du type

$$(8) \qquad U = f(I, PDD),$$

exprimant la relation existant entre les paramètres U, I et PDD.

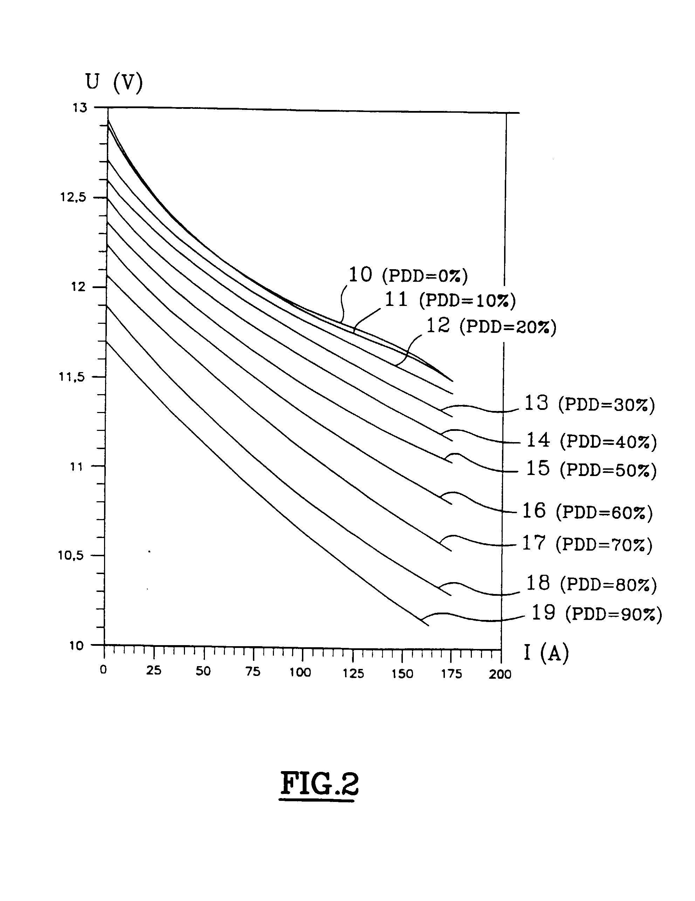

En pratique, et comme représenté en figure 2, on établit des courbes donnant la tension U (en volts) en fonction de I (en ampères) pour diverses valeurs de profondeur de décharge PDD, par exemple 10 courbes référencées 10 à 19 en figure 2, correspondant à des profondeurs de décharge croissantes de 0%, 10%, 20%, 30%, 40%,...90%. Les courbes 10 à 19 sont ensuite échantillonnées et stockées sous forme numérique dans la mémoire programme d'un microprocesseur, par exemple le microprocesseur 1 de la figure 1 que l'on équipe d'un détecteur 10 de tension U. Grâce à ces courbes, le microprocesseur 1 peut faire une évaluation cyclique de la profondeur de décharge PDD de la batterie, après avoir mesuré U et I.

Une telle méthode présente certains avantages mis en lumière par des études conduites par la demanderesse. Ces avantages découlent des constatations suivantes:

- i) la tension U d'une batterie, pour un courant I et une profondeur de décharge PDD donnés, évolue très peu avec le vieillissement de la batterie,
- ii) au-delà des 10% de profondeur de décharge PDD, pour un courant I donné, la tension U évolue avec la profondeur de décharge PDD, comme on peut l'observer sur la figure 2 où l'on voit que les diverses courbes de tension U ne se superposent pas,
- iii) la tension U est directement fonction de la température T de la batterie, U diminuant lorsque la température baisse,
- iiii) la tension U pour une profondeur de décharge PDD donnée est insensible au profil de décharge subit par la batterie.

De la constatation i), il résulte que les courbes de polarisation représentées en figure 2 sont valables tout au long de la vie de la batterie. De ii), que la tension U et la profondeur de décharge PDD sont deux paramètres liés, la connaissance de U permettant ainsi de connaître la PDD. De iii), que le paramètre température est implicitement pris en compte si l'on se réfère aux courbes de polarisation de la figure 2 pour déterminer la profondeur de décharge PDD. Enfin, la constatation iiii) confirme le fait que U et PDD sont deux paramètres liés par une relation indépendante des autres paramètres de fonctionnement de la batterie.

En résumé, il découle de ces constatations qu'une méthode estimative est une méthode fiable pour déterminer l'état de charge d'une batterie.

En revanche, une telle méthode n'est pas précise. En effet, on ne peut pas, au moyen d'une dizaine de courbes, estimer la profondeur de décharge avec une précision de l'ordre du pour-cent, à moins bien entendu de procéder à de nombreuses expérimentations pour tracer un grand nombre de courbes de polarisation, ce qui rendrait la méthode très lourde à mettre en oeuvre.

Finalement, on trouve dans l'art antérieur des méthodes coulométriques qui sont précises mais ne sont pas fiables et des méthodes estimatives qui sont fiables mais ne sont pas précises, dans la mesure où l'on souhaite mettre en oeuvre ces méthodes de façon simple.

Un objectif de la présente invention est de prévoir un procédé de détermination de la profondeur de décharge d'une batterie d'accumulateurs qui soit à la fois précis et fiable tout en étant simple à mettre en oeuvre.

Pour atteindre cet objectif, l'idée de la présente invention et de combiner les deux méthodes classiques qui viennent d'être décrites d'une manière permettant de bénéficier des avantages de chacune sans en avoir les inconvénients. Plus précisément, une première idée de la présente invention est d'utiliser une méthode coulométrique, en raison de sa précision, pour calculer la profondeur de décharge d'une batterie, puis de vérifier au moyen d'une méthode estimative, en raison de sa fiabilité, que la profondeur de décharge calculée par la méthode coulométrique est exacte. Une deuxième idée de la présente invention est de corriger en cours de calcul au moins une partie des coefficients de rendement utilisés par la méthode coulométrique si cette méthode donne une profondeur de décharge qui s'éloigne trop de la profondeur de décharge estimée.

Ainsi, essentiellement, la présente invention prévoit un procédé pour déterminer la profondeur de décharge d'une batterie, comprenant les opérations cycliques consistant à : calculer la profondeur de décharge de la batterie en faisant le décompte des quantités d'électricité émises par la batterie et en appliquant à chaque quantité d'électricité un coefficient de rendement choisi parmi une pluralité de coefficients de rendement prédéterminés expérimentalement ; estimer la profondeur de décharge de la batterie à partir d'une mesure de la tension de la batterie et du courant traversant la batterie ; comparer la profondeur de décharge calculée à la profondeur de décharge estimée, et quand l'écart entre la profondeur de décharge calculée et la profondeur de décharge estimée est supérieur à un seuil prédéterminé, corriger au moins une partie des coefficients de rendement de la pluralité de coefficients de rendement de manière que la profondeur de décharge calculée tende à se rapprocher de la profondeur de décharge estimée, la profondeur de décharge calculée constituant le résultat du procédé.

On voit que grâce à la présente invention, on "fiabilise" la méthode coulométrique grâce à la méthode estimative, les coefficients de rendement étant corrigés autant de fois que nécessaire. On peut donc mettre en oeuvre la méthode coulométrique de façon simple.

Ainsi, selon un mode de réalisation particulièrement avantageux en raison de sa simplicité, les coefficients de rendement sont prédéterminés expérimentalement en fonction uniquement de deux paramètres, ces paramètres étant le courant traversant la batterie et la profondeur de décharge de la batterie.

Selon un mode de réalisation, quand l'écart entre la profondeur de décharge calculée et la profondeur de décharge estimée est supérieur au seuil prédéterminé, il est prévu de corriger au moins les coefficients de rendement du domaine de profondeur de décharge dans lequel se trouve la batterie et les coefficients de rendement du domaine suivant de profondeur de décharge.

Selon un mode de réalisation, la correction des coefficients de rendement comprend une étape consistant à ajouter aux coefficients un terme correcteur fonction de l'écart entre la profondeur de décharge mesurée et la profondeur de décharge estimée.

Avantageusement, le terme correcteur est au moins déterminé par le produit de l'écart entre la profondeur de décharge mesurée et la profondeur de décharge estimée et de l'écart entre les coefficients de rendement auquel le terme correcteur doit être appliqué et les coefficients de rendement du domaine suivant de profondeur de décharge.

Selon un mode de réalisation, la comparaison entre la profondeur de décharge calculée et la profondeur de décharge estimée est effectuée lorsque la profondeur de décharge estimée passe d'un domaine de profondeur de décharge à un autre.

La comparaison peut aussi être effectuée lorsque la profondeur de décharge calculée passe d'un domaine de profondeur de décharge à un autre.

Par ailleurs, quand un courant est susceptible d'être fourni occasionnellement à la batterie, la pluralité de coefficients de rendement comprend des coefficients de rendement applicables aux quantités d'électricité reçues par la batterie et des coefficients de rendement applicables aux quantités d'électricité émises par la batterie.

Ces caractéristiques, avantages ainsi que d'autres de la présente invention apparaîtront plus clairement à la lecture de la description suivante d'un mode de réalisation du procédé de l'invention dans le cadre d'une application à une batterie d'accumulateurs de véhicule automobile électrique, faite à titre non limitatif en relation avec les figures jointes parmi lesquelles :

- la figure 1 déjà décrite représente un système à microprocesseur classique pouvant être utilisé pour la mise en oeuvre du procédé de l'invention,
- la figure 2 déjà décrite représente à titre d'exemple des courbes de polarisation d'une batterie d'accumulateurs, illustrant la relation entre la tension et le courant de batterie,
- la figure 3 représente à titre d'exemple des courbes de rendement d'une batterie d'accumulateurs, illustrant les variations du rendement de la batterie en fonction de la profondeur de décharge et du courant de batterie, et
- la figure 4 représente un organigramme de programmation du microprocesseur de la figure 1 pour la mise en oeuvre du procédé de l'invention.

Dans ce qui suit, on va décrire un exemple de réalisation du procédé de l'invention appliqué à une batterie d'accumulateurs de véhicule automobile électrique. Le procédé est mis en oeuvre au moyen du dispositif classique à microprocesseur déjà décrit en relation avec la figure 1, le moteur 7 alimenté par la batterie 6 étant ici un moteur de traction de véhicule automobile.

Essentiellement, pour déterminer la profondeur de décharge PDD de la batterie 6, la présente invention propose de combiner une méthode coulométrique du type décrit au préambule et une méthode estimative également décrite au préambule.

Plus précisément, le procédé de l'invention comprend de façon cyclique les étapes suivantes :

- déterminer la profondeur de décharge de la batterie 6 au moyen d'une méthode coulométrique, c'est-à-dire en faisant le décompte des quantités d'électricité $Q_i$ émises par la batterie et en appliquant à chaque quantité d'électricité $Q_i$ un coefficient de rendement $K_j$ choisi parmi une pluralité de coefficients de rendement $K_1...K_n$, la profondeur de décharge calculée par cette première méthode étant désignée PDDa,

- déterminer la profondeur de-décharge de la batterie 6 au moyen d'une méthode estimative, c'est-à-dire à partir d'une mesure de la tension U et du courant I de batterie 6 et au moyen de courbes de polarisation représentant la relation entre U et I pour diverses profondeurs de décharge, la profondeur de décharge estimée grâce à cette deuxième méthode étant désignée PDDu,
- comparer PDDa et PDDu, et
- si un écart significatif est constaté entre PDDa et PDDu, corriger des coefficients de rendement $K_j$ utilisés par la méthode coulométrique de manière que PDDa tende à se rapprocher de PDDu.

En d'autres termes, la combinaison selon l'invention des deux méthodes classiques consiste à définir deux échelles de profondeur de décharge, respectivement PDDa et PDDu, la première échelle PDDa étant une échelle de mesure et la deuxième PDDu une échelle de référence, et faire en sorte que la première échelle coïncide avec la seconde.

L'échelle PDDa étant l'échelle de mesure, l'information qui sera communiquée à un utilisateur, par exemple au moyen de l'afficheur 9 de la figure 1, sera la profondeur de décharge PDDa.

En pratique, la mise en oeuvre du procédé de l'invention suppose que les étapes préliminaires suivantes soient réalisées :

- la mise en oeuvre de la méthode coulométrique et l'élaboration expérimentale des coefficients $K_j$,
- la mise en oeuvre de la méthode estimative et l'élaboration expérimentale de courbes de polarisations donnant la relation entre U, I, et la profondeur de décharge,
- le choix d'un événement qui va déterminer l'instant de la comparaison des valeurs PDDa et PDDu données par chacune des deux méthodes,
- le choix d'une méthode de comparaison de PDDa et PDDu,
- le choix des coefficients de rendement $K_j$ à corriger lorsqu'une correction s'avère nécessaire, et
- le choix d'une méthode de correction des coefficients de rendement $K_j$.

Ces étapes préliminaires seront maintenant décrites. Mise en oeuvre de la méthode coulométrique

Il s'agit d'une étape en elle-même classique et bien connue de l'homme de l'art. On détermine expérimentalement un ensemble de coefficients $K_j$ qui représentent le rendement de la batterie dans diverses conditions de fonctionnement. En principe, et comme on l'a indiqué au préambule, les coefficients de rendement $K_j$ devraient être déterminés en fonction de tous les paramètres susceptibles d'affecter le rendement de la batterie. Mais on a vu que dans l'art antérieur la recherche d'une moindre complexité conduisait le plus souvent à déterminer les coefficients $K_j$ en fonction seulement de la tension U, de la profondeur de décharge PDD et de la température T, au détriment de la fiabilité du résultat.

Grâce à la présente invention, on va pouvoir simplifier encore plus la méthode coulométrique sans nuire à la fiabilité du résultat final. Ainsi, on va déterminer les coefficients $K_j$ à partir de deux paramètres seulement qui sont le courant I de batterie et la profondeur de décharge PDD.

Plus précisément, on définit un certain nombre de domaines de courant $DI_x$ couvrant toutes les valeurs possibles du courant I, par exemple 5 domaines $DI_1$ à $DI_5$, et un certain nombre de domaines de profondeur de décharge $DPDDay$, par exemple quatre domaines $DPDDa_1$ à $DPDDa_4$. On définit ensuite expérimentalement, pour chaque combinaison $\{DI_x, DPDDa_y\}$ d'un domaine $DI_x$ et d'un domaine $DPDDa_y$ un coefficient de rendement $K_j$ utilisable pour l'ensemble des valeurs de-profondeur de décharge PDD et de courant I couvertes par la combinaison $\{DI_x, {}^{DPDDay}\}$.

Par la suite, pour faciliter la description du procédé de l'invention, on désignera les coefficients de rendement $K_j$ par $K_{x,y}$, "x" et "y" étant des indices représentant respectivement le domaine de courant $DI_x$ et le domaine de profondeur de décharge $DPDDa_y$ auxquels est affecté chaque coefficient $K_{x,y}$.

Le tableau 1 ci-après résume l'organisation générale de la méthode, pour une batterie dont la charge de référence Cref est égale à 60 ampères-heures. Les domaines $DPDDa_y$ de profondeur de décharge PDDa sont exprimés en pourcentage de la charge totale Cref de la batterie et couvrent de 0 à 90% de profondeur de décharge (on ne souhaite généralement pas décharger la batterie au delà de 90%). Les domaines de courant $DI_x$ sont choisis pour couvrir l'ensemble des valeurs possibles du courant I. Chaque coefficient $K_{x,y}$ est déterminé par un test de type classique qui comprend les opérations suivantes :

- amener la batterie dans un état de profondeur de décharge $PDDa_{test}$ représentatif du domaine $DPDDa_y$ du coefficient $K_{x,y}$ à déterminer, au moyen d'impulsions de décharge de référence calibrées en intensité,
- faire émettre par la batterie un certain nombre d'impulsions de courant ayant une intensité $I_{test}$ représentative du domaine $DI_x$ du coefficient $K_{x,y}$ à déterminer,
- évaluer l'effet du test sur la charge de batterie relativement au régime de décharge de référence.

Le régime de décharge de référence de la batterie est par exemple réalisé au moyen d'impulsions normalisées du type TC69WG3, à une température de 20°C.

| | PDDa$_{test}$→ | 10% | 30% | 52,5% | 77,5% |
|---|---|---|---|---|---|
| tableau 1 | DPDDa$_y$→ | DPDDa$_1$ | DPDDa$_2$ | DPDDa$_3$ | DPDDa$_4$ |
| | | 0-20% | 20-40% | 40-65% | 65-90% |
| I$_{test}$ ↓ | DI$_x$ ↓ | | | | |
| 0,2 Cref | DI$_1$ | 0-20 Ah | K$_{1,1}$ | K$_{1,2}$ | K$_{1,3}$ | K$_{1,4}$ |
| 0,5 Cref | DI$_2$ | 20-40 Ah | K$_{2,1}$ | K$_{2,2}$ | K$_{2,3}$ | K$_{2,4}$ |
| 1 Cref | DI$_3$ | 40-80 Ah | K$_{3,1}$ | K$_{3,2}$ | K$_{3,3}$ | K$_{3,4}$ |
| 2 Cref | DI$_4$ | 80-160 Ah | K$_{4,1}$ | K$_{4,2}$ | K$_{4,3}$ | K$_{4,4}$ |
| 3 Cref | DI$_5$ | >160 Ah | K$_{5,1}$ | K$_{5,2}$ | K$_{5,3}$ | K$_{5,4}$ |

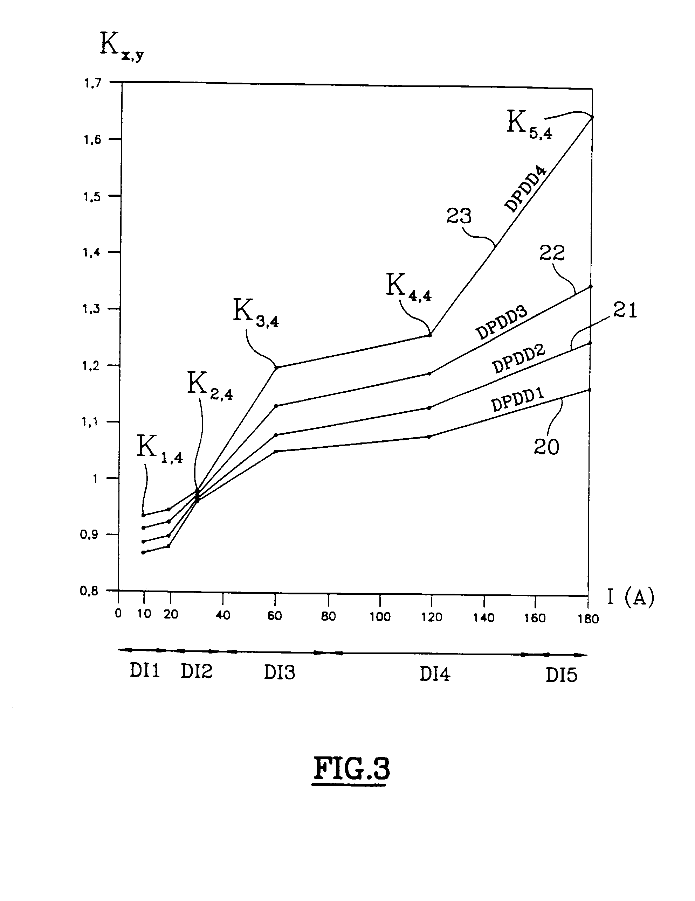

La figure 3 fait partie intégrante de la description et représente à titre d'exemple des courbes 20, 21, 22, 23 donnant le rendement en fonction de l'intensité du courant I et de la profondeur de décharge d'une batterie au plomb de 12 V et 60 ampères heures de marque HAGEN utilisée par la demanderesse pour la mise en oeuvre de l'invention. Chaque courbe correspond à l'un des quatre domaines de profondeur de décharge décrits précédemment, respectivement DPDDa$_1$, DPDDa$_2$, DPDDa$_3$, DPDDa$_4$, et couvre les cinq domaines de courant DI$_1$ à DI$_5$. De ces courbes, on peut déduire les valeurs des coefficients K$_{x,y}$ comme montré sur la courbe 23 (domaine DPDDa$_4$) où l'on a repéré les coefficients K$_{1,4}$ , K$_{2,4}$ , K$_{3,4}$ , K$_{4,4}$ et K$_{5,4}$.

Par ailleurs, dans le présent mode de réalisation, le moteur 7 est un moteur réversible utilisé comme alternateur pendant les phases de décélération du véhicule (frein moteur) afin de renvoyer de l'énergie électrique à la batterie d'accumulateurs 6. Dans ces conditions, il faut prévoir des coefficients de rendement K'$_{x,y}$ utilisables pendant les périodes de frein moteur. Les coefficients K$_{x,y}$ sont définis expérimentalement selon une méthode comparable à celle décrite précédemment, en envoyant dans la batterie des impulsions de courant I$_{test}$ de valeurs différentes, à diverses profondeur de décharge PDDa$_{test}$, le gain de charge induit dans la batterie étant comparé à celui obtenu au moyen d'impulsions de charge de référence. On définit ensuite un tableau 2 de valeurs K'$_{x,y}$ représenté ci-après, et l'on donne aux coefficients K'$_{x,y}$ une valeur négative pour prendre en compte la formulation de la relation (3) décrite au préambule.

| | PDDa$_{test}$→ | 10% | 30% | 52,5% | 77,5% |
|---|---|---|---|---|---|
| tableau 2 | DPDDa$_y$→ | DPDDa$_1$ | DPDDa$_2$ | DPDDa$_3$ | DPDDa$_4$ |
| | | 0-20% | 20-40% | 40-65% | 65-90% |
| I$_{test}$ ↓ | DI$_x$ ↓ | | | | |
| 0.2 Cref | DI$_1$ | 0+20 Ah | K'$_{1,1}$ | K'$_{1,2}$ | K'$_{1,3}$ | K'$_{1,4}$ |
| 0.5 Cref | DI$_2$ | 20+40 Ah | K'$_{2,1}$ | K'$_{2,2}$ | K'$_{2,3}$ | K'$_{2,4}$ |
| 1 Cref | DI$_3$ | 40+80 Ah | K'$_{3,1}$ | K'$_{3,2}$ | K'$_{3,3}$ | K'$_{3,4}$ |
| 2 Cref | DI$_4$ | 80+160 Ah | K'$_{4,1}$ | K'$_{4,2}$ | K'$_{4,3}$ | K'$_{4,4}$ |
| 3 Cref | DI$_5$ | 160+ Ah | K'$_{5,1}$ | K'$_{5,2}$ | K'$_{5,3}$ | K'$_{5,4}$ |

Les K$_{x,y}$ et les K'$_{x,y}$ ainsi déterminées sont enregistrées dans la mémoire programme 2 du microprocesseur 1, qui peut ensuite être programmé pour réaliser les microcycles de calcul du type déjà décrit au préambule et déterminer, à chaque microcycle, une valeur de profondeur de décharge PDDa.

Ici, à chaque microcycle, le microprocesseur 1 doit prendre en compte le signe du courant I et choisir un coefficient $K_{x,y}$ dans le tableau 1 ci-dessus si le courant I est négatif (courant débité par la batterie 6) ou un coefficient $K'_{x,y}$ dans le tableau 2 ci-dessus si le courant est positif (courant renvoyé par le moteur 7). Le coefficient $K_{x,y}$ ou $K'_{x,y}$ adéquat est choisi en fonction du courant I mesuré et du domaine $DPDDa_y$ dans lequel se trouve la batterie. Le domaine $DPDDa_y$ sera déterminé à partir de la valeur de profondeur de décharge PDDa calculée au microcycle précédent.

**Mise en oeuvre de la méthode estimative**

En raison des avantages résultant de la combinaison des deux méthodes, il n'est pas nécessaire de viser ici une très grande précision. On peut donc se contenter d'un nombre limité de courbes de polarisations, ce qui apportera l'avantage d'une mise en oeuvre simple, rapide et peu coûteuse.

Ainsi, le faisceau de courbes de polarisation de la figure 2, comprenant seulement dix courbes 10 à 19, a été utilisé par la demanderesse pour la réalisation de l'invention. Ces courbes 10 à 19 ont été tracées à partir de la batterie HAGEN de 12V-60Ah déjà citée et font partie intégrante de la description. Bien entendu, il appartiendra à l'homme de l'art de définir un autre faisceau de courbes si un autre type de batterie est utilisé.

Une fois déterminées, les courbes 10 à 19 ou autres courbes équivalentes sont échantillonnées puis numérisées et stockées dans la mémoire programme 2 du microprocesseur 1 de la figure 1. La méthode d'estimation de la profondeur de décharge PDDu à partir des courbes 10 à 19 est mise en mémoire sous forme de logiciel dans la mémoire programme 2.

La présente invention propose une méthode d'estimation particulièrement simple à mettre en oeuvre, qui va maintenant être décrite. On rappelle tout d'abord que les courbes 10 à 19 de la figure 2 correspondent à des profondeurs de décharge croissantes de la batterie 6, respectivement de 0%, 10%, 20%, jusqu'à 90%. Les dix courbes 10 à 19 définissent ainsi dix domaines de profondeur de décharge que l'on désignera par $DPDDU_z$ pour les distinguer des domaines $DPDDa_y$ de la méthode coulométrique. Le premier domaine $DPDDU_0$ est centré sur le 0% (courbe 10), le deuxième domaine $DPDDu_1$ sur les 10% (courbe 11), etc., le neuvième domaine $DPDDu_9$ centré sur les 90% (courbe19) .

Ainsi, lorsqu'un couple (U,I) de valeurs de tension U et de courant I est mesuré par le microprocesseur 1, on propose que le microprocesseur 1 identifie la position du point sur la figure 2, détermine la courbe 10 à 19 la plus proche de ce point selon l'axe de la tension U (l'axe vertical sur la figure 2), et prenne comme valeur de PDDu celle correspondant à la courbe la plus proche, par exemple 70% si cette courbe est la courbe 17, 80% si cette courbe est la courbe 18, etc.

Toutefois, l'homme de l'art pourra prévoir diverses autres manières de procéder, par exemple celle qui consiste à estimer plus précisément PDDu par interpolation.

**Choix d'un événement qui va déterminer l'instant de la comparaison entre PDDa calculée et PDDu estimée**

Une fois les deux méthodes définies et programmées, le microprocesseur 1 est en mesure de réaliser des microcycles de calcul de PDDa et d'estimation de PDDu, et de comparer les deux valeurs PDDa et PDDu.

Le microprocesseur 1 pourrait faire la comparaison de PDDa et de PDDu à chaque microcycle, mais a priori cela ne présente pas d'intérêt dans la mesure où la méthode estimative est peu précise, surtout si l'on choisit de faire une estimation globale de la profondeur 5 de décharge PDDu par tranches de 10% comme on l'a proposé précédemment.

Dans ces conditions, la présente invention propose d'effectuer la comparaison lorsque la profondeur de décharge PDDu change de domaine $DPDDU_z$ sur l'échelle PDDu. La profondeur de décharge PDDu change de domaine lorsque sur la figure 2 les courbes les plus proches de deux points P1 et P2 déterminées par deux couples de valeurs $(U,I)_i$ et $(U,I)_{i+1}$ mesurées lors de deux microcycles successifs ne sont pas les mêmes. Sur l'exemple montré en figure 2, le point P1 est proche de la courbe 17 et appartient au domaine $DPDDu_7$ centré sur les 70% de profondeur de décharge. Le point P2 est proche de la courbe 18 et appartient au domaine $DPDDU_8$ centré sur les 80% de profondeur de décharge.

Bien entendu, l'homme de l'art pourra prévoir d'autres moyens de déclenchement de la comparaison. Par exemple, une variante consiste à déclencher la comparaison de PDDa et PDDu lorsque la profondeur de décharge mesurée PDDa change de domaine $DPDDU_z$ sur l'échelle PDDu. Une autre variante consiste à déclencher la comparaison lorsque l'une des deux valeurs de profondeur de décharge PDDa et PDDu change de domaine $DPDDU_z$ sur l'échelle PDDu.

**Choix d'une méthode de comparaison de PDDa et PDDu**

Ici, on va prendre comme hypothèse le fait qu'un écart significatif entre PDDa et PDDu ne va se produire que dans le cas où la profondeur de décharge calculée PDDa est inférieure à la profondeur de décharge estimée PDDu.

Cette hypothèse est confirmée par la pratique où l'on constate que la méthode coulométrique donne toujours une profondeur de décharge PDDa qui est "optimiste" ou en "retard" vis-à-vis de la profondeur de décharge PDDu donnée par mesure de la tension U et du courant I. De plus, il existe de nombreuses causes accidentelles susceptibles de provoquer une baisse de charge de la batterie qui ne seront pas prises en compte par la méthode coulométrique mais seront détectées par la mesure de la tension U, comme par exemple un vieillissement prématuré de la batterie, un rechargement de la batterie qui n'est pas réalisé selon un profil de courant adéquat, la défaillance d'un accumulateur, etc. Enfin, cette hypothèse est également justifiée dans le présent mode de réalisation par le fait que le paramètre température T n'est pas pris en compte dans la prédétermination des coefficients de rendement $K_{x,y}$, de sorte qu'une baisse de la température T va provoquer une baisse de charge dans la batterie qui ne sera pas perçue par la méthode coulométrique mais sera implicitement prise en compte par la méthode estimative.

Dans ces conditions, selon l'invention, l'étape de comparaison peut consister à faire le test suivant :

$$(9) \qquad PDDu - PDDa > SX$$

SX étant un seuil de consigne positif et prédéterminé, choisi par exemple égal à 4%.

### Choix des coefficients de rendement à corriger

Selon l'invention, quand l'écart entre PDDu est PDDa est supérieur au seuil SX, le microprocesseur doit corriger certains des coefficients $K_{x,y}$ et $K_{x,y}$ de manière que la profondeur de décharge mesurée PDDa "rattrape" progressivement le retard qu'elle présente vis-à-vis de la profondeur de décharge estimée PDDu.

La présente invention propose de corriger les coefficients $K_{x,y}$ et $K_{x,y}$ du domaine $DPDDa_y$ dans lequel se trouve la profondeur de décharge PDDa au moment où l'écart est constaté, ainsi que les coefficients $K_{x,y+1}$ et $K'_{x,y+1}$ du domaine suivant $DPDDa_{y+1}$ de profondeur de décharge (dans le sens d'une plus grande décharge).

Ainsi, par exemple, si à un instant donné l'échelle PDDa indique 35% de profondeur de décharge et l'échelle PDDu indique 40%, le microprocesseur 1 corrige les coefficients $K_{x,2}$ et $K'_{x,2}$ du domaine de profondeur de décharge $DPDDa_2$ dans lequel se trouve l'échelle PDDa, ainsi que les coefficients $K_{x,3}$, $K'_{x,3}$ du domaine suivant $DPDDa_3$ de profondeur de décharge. Le tableau 1 représenté précédemment comprend alors dans ses colonnes $DPDDa_2$ et $DPDDa_3$ des coefficients corrigés $K^*_{x,y}$ comme représenté ci-après.

| Tableau 2 | DPDDa1<br>0-20% | DPDDa2<br>20-40% | DPDDa3<br>40-65% | DPDDa4<br>65-90% |
|---|---|---|---|---|
| DI1 | $K_{1,1}$ | $K^*_{1,2}$ | $K^*_{1,3}$ | $K_{1,4}$ |
| DI2 | $K_{2,1}$ | $K^*_{2,2}$ | $K^*_{2,3}$ | $K_{2,4}$ |
| DI3 | $K_{3,1}$ | $K^*_{3,2}$ | $K^*_{3,3}$ | $K_{3,4}$ |
| DI4 | $K_{4,1}$ | $K^*_{4,2}$ | $K^*_{4,3}$ | $K_{4,4}$ |
| DI5 | $K_{5,1}$ | $K^*_{5,2}$ | $K^*_{5,3}$ | $K_{5,4}$ |

Le mode de correction qui vient d'être proposé n'est pas impératif. En fonction de l'application et du type de batterie utilisée, l'homme de l'art pourra prévoir d'autres modes de correction, et notamment :

- un mode consistant à corriger uniquement les termes $K_{x,y}$, $K'_{x,y}$ du domaine de profondeur de décharge $PDDa_y$ dans lequel se trouve l'échelle PDDa,
- un mode consistant à corriger les termes $K_{x,y}$ et $K'_{x,y}$ de tous les domaines suivants de profondeur de décharge $DPDDa_y$, $DPDDa_{y+1}$, $DPDDa_{y+2}$ jusqu'au dernier.

On peut également envisager de ne corriger que les $K_{x,y}$ et $K'_{x,y}$ du domaine de courant $DI_x$ dans lequel se trouve le courant I au moment où la correction doit être réalisée, mais cette solution risque de conduire à des incohérences de résultat.

Enfin, il doit être noté que si l'on ne corrige ici que les $K_{x,y}$ du domaine $DPDDa_y$ en cours et les $K_{x,y}$ des domaines $DPDDa_{y+1...}$ de plus grande décharge, c'est que l'on a pris comme hypothèse déjà décrite le fait qu'un écart significatif entre PDDa et PDDu ne va se produire que dans le cas où PDDa est inférieure à PDDu.

## Méthode de correction des coefficients de rendement.

Pour corriger les coefficients $K_{x,y}$ et $K'_{x,y}$, on pourrait définir expérimentalement plusieurs jeux de valeurs de remplacement $K^*_{x,y}$ $K'^*_{x,y}$ qui seraient stockées dans la mémoire programme 2, mais cette solution serait lourde à mettre en oeuvre.

La présente invention propose plutôt de prévoir une correction automatique des coefficients $K_{x,y}$ élaborée de manière à faire coïncider au mieux les deux échelles PDDa et PDDu. Essentiellement, cette correction consiste à ajouter aux coefficients $K_{x,y}$ un terme correcteur $\Gamma$ fonction de l'écart entre PDDa et PDDu. Il est outre avantageux que $\Gamma$ soit aussi fonction de l'écart entre les $K_{x,y}$ à corriger et les $K_{x,y+1}$ du domaine suivant $DPDDa_{y+1}$ de profondeur de décharge, ainsi que, éventuellement, de l'écart entre les $K_{x,y+1}$ et les $K_{x,y+2}$ des deux domaines $DPDDa_{y+1}$, $DPDDa_{y+2}$ suivants.

Ainsi, selon l'invention, la correction des coefficients $K_{x,y}$ peut être réalisée par le microprocesseur 1 de la façon suivante :

$$(10) \qquad K^*_{x,y} = K_{x,y} + \Gamma$$

$\Gamma$ étant par exemple égal à :

$$(11) \qquad \Gamma = k \, \Delta PDD \, [(K_{x,y+1}\text{-}K_{x,y})+(K_{x,y+2}\text{-}K_{x,y+1})]$$

k étant une constante choisie par exemple égale à 0.1, $\Delta PDD$ représentant l'écart entre PDDu et PDDa (exprimés ici en pourcentage) .

Bien entendu, la correction est effectuée ligne par ligne dans le tableau 1, c'est-à-dire par domaines de courant $DI_x$.

Par ailleurs, pour la correction des $K_{x,y}$ de l'avant-dernier domaine $DPDDa_y$, le terme correcteur $\Gamma$ s'écrira :

$$(12) \qquad \Gamma = k \, \Delta PDD \, [(K_{x,y+1}\text{-}K_{x,y})]$$

et pour la correction des $K_{x,y}$ du dernier domaine $DPDDa_y$ :

$$(13) \qquad \Gamma = k \, \Delta PDD$$

Une fois les coefficients $K_{x,y}$ corrigés, les coefficients $K'_{x,y}$ sont à leur tour corrigés, de la même manière.

Bien entendu, les solutions et méthodes proposées dans la présente description pour la mise en oeuvre du procédé de l'invention ne sont données qu'à titre d'exemple. Elles reflètent l'état actuel des connaissances de la demanderesse et sont susceptibles de modifications.

## Exemple d'organigramme de programmation

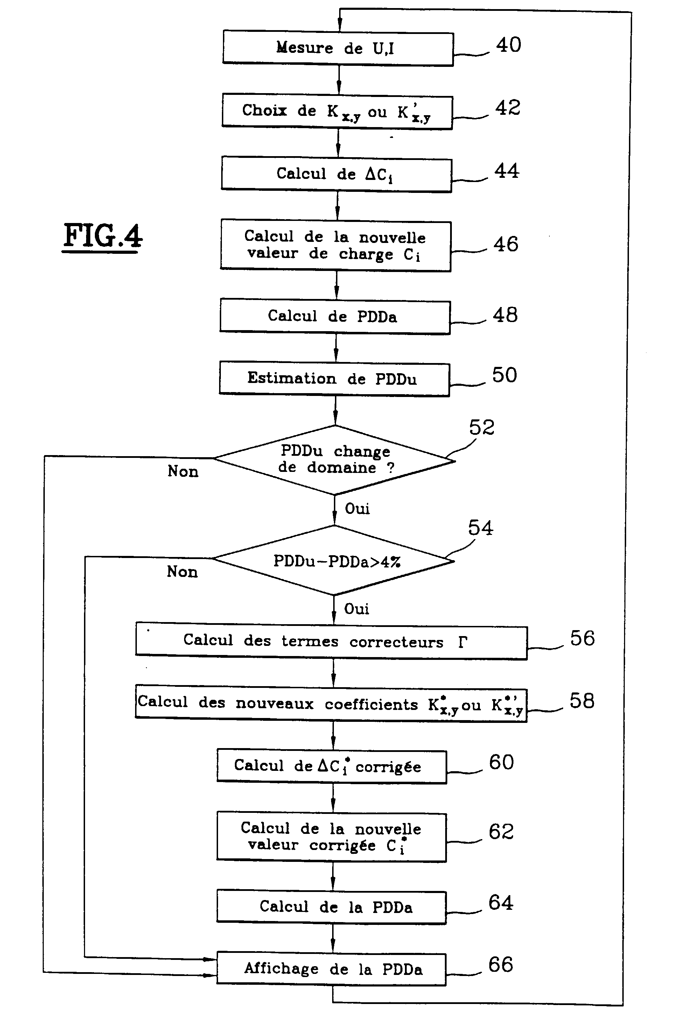

La figure 4 donne un exemple d'organigramme de programmation du microprocesseur 1 pour la réalisation d'un microcycle de calcul selon le procédé de l'invention, comprenant des étapes de calcul de PDDa, d'estimation de PDDu, de comparaison de PDDa et PDDu et de correction éventuelle des coefficients $K_{x,y}$ et $K_{x,y}$. L'organigramme de la figure 4 représente les étapes essentielles du procédé de l'invention, les détails de mise en oeuvre de ces étapes ayant été décrits précédemment. On y trouve 14 étapes, référencées 40 à 66. Etape 40 : le microprocesseur 1 mesure de la tension moyenne U aux bornes de la batterie 6 et le courant moyen I débité ou reçu par la batterie.

Etape 42 : le microprocesseur 1 choisit un coefficient $K_{x,y}$ ou $K'_{x,y}$ (tableau 1 ou tableau 2 décrits plus haut) en fonction du signe du courant I, de la valeur du courant I et de la profondeur de décharge PDDa calculé au microcycle précédent, de rang i-1, i représentant le rang du microcycle en cours.

Etape 44 : le microprocesseur 1 calcule la variation de charge de la batterie :

$$(14) \qquad \Delta C_i = K_{x,y} \, I \, \Delta t$$

ou (selon le signe du courant) :

$$(15) \qquad \Delta C_i = K'_{x,y} \: I \: \Delta t$$

$\Delta t$ étant la durée du microcycle, choisie par exemple de l'ordre de la dixième de seconde.

Etape 46 : le microprocesseur 1 calcule la nouvelle valeur $C_i$ de la charge de la batterie, soit

$$(16) \qquad C_i = C_{i-1} - \Delta C_i$$

$C_{i-1}$ étant la charge calculée au microcycle précédent. A noter que $C_i$ peut être supérieure à $C_{i-1}$ si le microprocesseur 1 a choisi un coefficient $K'_{x,y}$ à l'étape 44, les coefficients $K'_{x,y}$ étant de signe négatif.

Etape 48 : le microprocesseur 1 calcule la profondeur de décharge PDDa de la batterie :

$$(17) \qquad PDDa = 100[(Cref - C_i) \: /Cref] \: \%$$

Cref étant la charge de référence de la batterie.

Etape 50 : à partir des courbes de polarisation 10 à 19 (figure 2) et des valeurs U et I mesurées, le microprocesseur 1 estime la profondeur de décharge PDDu en recherchant la courbe 10 à 19 la plus proche du couple de valeurs {U, I}, comme proposé précédemment.

Etape 52 : le microprocesseur 1 détermine si PDDu a changé de domaine, c'est-à-dire si la courbe la plus proche trouvée à l'étape 50 du microcycle en cours n'est pas la même que la courbe la plus proche trouvée à l'étape 50 du microcycle précédent. Si PDDu a changé de domaine, le microprocesseur 1 va à l'étape 54 suivante. Sinon, il va à l'étape 66 décrite plus loin.

Etape 54 : le microprocesseur 1 compare PDDa à PDDu en réalisant le test (9) déjà décrit :

$$(9) \qquad PDDu - PDDa > SX$$

le seuil SX étant ici choisi égal à 4%. Si le test est concluant, la valeur PDDa donnée par la méthode coulométrique est erronée et des coefficients $K_{x,y}$ et $K'_{x,y}$ doivent être corrigés, le microprocesseur 1 va à l'étape suivante 58. Sinon, il va à l'étape 66

Etape 58 : le microprocesseur 1 calcule les nouveaux termes $K^*_{x,y}$ et $K^{*'}_{x,y}$ selon la méthode proposée précédemment, pour le domaine de profondeur de décharge $DPDDa_y$ en cours, ainsi que le domaine suivant $DPDDa_{y+1}$ si ce domaine existe.

Etape 60 : le microprocesseur 1 refait le calcul de la variation de charge $\Delta C_i$ de la batterie, c'est-à-dire calcule une valeur corrigée $\Delta C^*_i$ de la même manière qu'à l'étape 44 mais avec les nouveaux coefficients $K^*_{x,y}$ ou $K^{*'}_{x,y}$ :

$$(18) \qquad \Delta C^*_i = K^*_{x,y} \: I \: \Delta t$$

ou (selon le signe du courant) :

$$(19) \qquad \Delta C^*_i = K^{*'}_{x,y} \: I \: \Delta t$$

Etape 62 : le microprocesseur 1 calcule la nouvelle valeur corrigée $C^*_i$ de la charge de la batterie, soit

$$(20) \qquad C^*_i = C_{i-1} - \Delta C^*_i$$

Etape 64 : le microprocesseur 1 recalcule la profondeur de décharge PDDa de la batterie :

$$(21) \qquad PDDa = 100[(Cref - C^*_i) \: /Cref] \: \%$$

Etape 66 : le microprocesseur 1 affiche à l'utilisateur la profondeur de décharge calculée PDDa, au moyen de l'afficheur 9 (figure 1), et retourne à l'étape 40 pour réaliser un nouveau·microcycle de calcul, de rang i+1.

On notera que l'étape de mesure 40 doit s'étendre sur la quasi totalité de la durée $\Delta t$ du microcycle, de manière que le décompte des quantités d'électricité $Q_i$ ne soit pas entaché d'erreur. Les étapes 42 à 66 doivent donc être réalisées rapidement ou réalisées en temps partagé pendant l'exécution de l'étape 40 du microcycle suivant.

**Particularités de mise en oeuvre dans le cas d'une batterie de traction d'un véhicule automobile électrique**

Le microcycle qui vient d'être décrit est répété indéfiniment depuis l'instant où le véhicule commence à être utilisé jusqu'au moment où il cesse de l'être. Au premier microcycle, le microprocesseur 1 doit disposer d'une valeur initiale de charge pour commencer le calcul itératif de la profondeur de décharge PDDa. Deux cas sont envisageables :

> i) si la batterie vient d'être entièrement rechargée, le microprocesseur 1 prend comme valeur initiale la charge de référence Cref de la batterie, par exemple 60 ampères-heures pour une batterie de 60 ampères-heures.
> ii) si la batterie n'a pas été rechargée, le microprocesseur 1 prend la valeur de charge $C_i$ calculée au dernier microcycle de la dernière utilisation du véhicule, cette valeur $C_i$ ayant été mise en mémoire.

Toutefois, il est possible dans le premier cas (i) que la batterie n'ait pas été entièrement rechargée et dans le deuxième cas (ii) qu'une chute brutale de la température extérieure se soit produite. Dans ces conditions, il est avantageux de prévoir une phase d'initialisation du procédé de l'invention au cours de laquelle le microprocesseur 1 fait un estimation de la profondeur de décharge PDDu par mesure de la tension U, en déduit une valeur de charge Co selon la relation suivante :

$$(22) \qquad C_0 = Cref - (PDDu \times Cref)/100$$

et vérifie ensuite que $C_0$ correspond à Cref (cas i) ou à $C_i$ mis en mémoire (cas ii). Si les valeurs ne concordent pas, le microprocesseur 1 prendra Co comme valeur initiale de charge.

Par ailleurs, lorsqu'un cycle de décharge de la batterie est terminé et que la batterie a été rechargée, la question se pose de savoir si l'on doit conserver les coefficients corrigés $K^*_{x,y}$ $K^{*'}_{x,y}$ calculés par le microprocesseur au cours de l'ancien cycle de décharge ou si l'on doit reprendre les coefficients $K_{x,y}$, $K'_{x,y}$ initialement présents dans la mémoire programme 2. Si la cause qui a provoqué l'écart entre DPDDu et DPDDa et a conduit à la correction des coefficients $K_{x,y}$, $K'_{x,y}$ est une cause permanente, par exemple une défaillance de l'un des accumulateurs de la batterie, on aura intérêt à conserver les coefficients corrigés $K^*_{x,y}$, $K^{*'}_{x,y}$. Si par contre l'écart entre DPDDu et DPDDa provenait d'une cause temporaire, par exemple une baisse de la température due à des conditions climatiques défavorables, on aura intérêt à les effacer. Pour résoudre ce problème, la présente invention propose de prévoir une solution du type auto-apprentissage : le microprocesseur 1 ne conserve pas, dans un premier temps, les coefficients corrigés $K^*_{x,y}$, $K^{*'}_{x,y}$. Puis, après plusieurs cycles de décharge de labatterie, si le microprocesseur constate qu'une correction des coefficients $K_{x,y}$, $K'_{x,y}$ originels doit être réalisée systématiquement, il remplace de façon définitive ces coefficients par des coefficients corrigés $K^*_{x,y}$, $K^{*'}_{x,y}$.

Enfin, on a vu que la détermination de la profondeur de décharge PDDu repose sur la-mesure de la tension U aux bornes de la batterie. Or, dans des conditions réelles de fonctionnement, il arrive qu'une batterie présente des baisses de tension aléatoires qui ne sont pas représentatives de sa profondeur de décharge. Pour pallier cet inconvénient, on pourra programmer le microprocesseur de manière que la correction des coefficients $K_{x,y}$, $K'_{x,y}$ ne soit effectuée qu'après avoir constaté pendant plusieurs microcycles un écart anormal entre la profondeur de décharge calculée PDDa et la profondeur estimée PDDu.

Dans ce qui précède, on a utilisé par commodité les notions de "profondeur de décharge" et de "domaines de profondeur de décharge" pour décrire la mise en oeuvre de l'invention. La profondeur de décharge étant directement fonction de la charge de la batterie (voir relations (6) et (17)) on aurait pu tout aussi bien mettre en oeuvre la présente invention sans passer par un calcul de profondeur de décharge, et utilisant des notions du type "charge estimée", "charge calculée", "domaines de charge calculée", "domaine de charge estimée", etc. Ainsi, les notions de "profondeur de décharge" et de "domaines de profondeur de décharge" ne devront pas être considérés comme des éléments nécessaires et essentiels à la présente invention, mais comme des éléments permettant simplement d'appréhender l'état de charge d'une batterie.

**Revendications**

1. Procédé pour déterminer la profondeur de décharge (PDDa) d'une batterie comprenant les opérations cycliques consistant à :

   - calculer la profondeur de décharge (PDDa) de la batterie en faisant le -décompte des quantités d'électricité ($Q_i$) émises par la batterie et en appliquant à chaque quantité d'électricité ($Q_i$) un coefficient de rendement ($K_{x,y}, K'_{x,y}$) choisi parmi une pluralité de coefficients de rendement ($K_{x,y}, K'_{x,y}$) prédéterminés expérimentalement,
   - estimer la profondeur de décharge (PDDu) de la batterie à partir d'une mesure de la tension (U) de la batterie et du courant (I) traversant la batterie,
   - comparer la profondeur de décharge calculée (PDDa) à la profondeur de décharge estimée (PDDu), et

   quand l'écart entre la profondeur de décharge calculée (PDDa) et la profondeur de décharge estimée (PDDu) est supérieur à un seuil prédéterminé (SX), corriger au moins une partie des coefficients de rendement ($K_{x,y}, K'_{x,y}$) de ladite pluralité de coefficients de rendement ($K_{x,y}, K'_{x,y}$) de manière que la profondeur de décharge calculée (PDDa) tende à se rapprocher de la profondeur de décharge estimée (PDDu), la profondeur de décharge calculée (PDDa) constituant le résultat du procédé.

2. Procédé selon la revendication 1, caractérisé en ce que lesdits coefficients de rendement ($K_{x,y}, K'_{x,y}$) sont prédéterminés expérimentalement en fonction uniquement de deux paramètres, lesdits paramètres étant le courant (I) traversant la batterie et la profondeur de décharge (PDDa) de la batterie.

3. Procédé selon l'une des revendications 1 et 2, caractérisé en ce que, quand l'écart entre la profondeur de décharge calculée (PDDa) et la profondeur de décharge estimée (PDDu) est supérieur audit seuil prédéterminé (SX), il est prévu de corriger au moins les coefficients de rendement ($K_{x,y}, K_{x,y}$) du domaine (DPDDay) de profondeur de décharge (PDDa) dans lequel se trouve la batterie et les coefficients de rendement ($K_{x,y+1}, K'_{x,y+1}$) du domaine suivant (DPDDa$_{y+1}$) de profondeur de décharge (PDDa) .

4. Procédé selon l'une des revendications 1 à 3, caractérisé en ce que ladite correction des coefficients de rendement ($K_{x,j}, K'_{x,j}$) comprend une étape consistant à ajouter auxdits coefficients un terme correcteur (r) fonction de l'écart entre la profondeur de décharge mesurée (PDDa) et la profondeur de décharge estimée (PDDu).

5. Procédé selon la revendication 4, caractérisé en ce que ledit terme correcteur ($\Gamma$) est au moins déterminé par le produit de :

   - l'écart ($\Delta PDD$) entre la profondeur de décharge mesurée (PDDa) et la profondeur de décharge estimée (PDDu) et de
   - l'écart entre les coefficients de rendement ($K_{x,y}, K'_{x,y}$) auquel le terme correcteur ($\Gamma$) doit être appliqué et les coefficients de rendement ($K_{x,y+1}, K_{x,y+1}$) du domaine suivant de profondeur de décharge (DPDDa$_{y+1}$).

6. Procédé selon la revendication 5, caractérisé en ce que ledit terme correcteur ($\Gamma$) est en outre déterminé par le produit de :

   - l'écart ($\Delta PDD$) entre la profondeur de décharge mesurée (PDDa) et la profondeur de décharge estimée (PDDu) et
   - l'écart entre les coefficients de rendement ($K_{x,y+1}, K'_{x,y+1}, K_{x,y+2}, K'_{x,y+2}$) des deux domaines suivants de profondeur de décharge (DPDDa$_{y+1}$, DPDDa$_{y+2}$).

7. Procédé selon l'une des revendications 1 à 6, caractérisé en ce que la comparaison entre profondeur de décharge calculée (PDDa) et la profondeur de décharge estimée (PDDu) est effectuée lorsque la profondeur de décharge estimée (PDDu) passe d'un domaine de profondeur de décharge (DPDDu$_z$) à un autre (DPDDu$_{z+1}$),

8. Procédé selon l'une des revendications 1 à 6, caractérisé en ce que la comparaison entre la profondeur de décharge calculée (PDDa) et la profondeur de décharge estimée (PDDu) est effectuée lorsque la profondeur de décharge calculée (PDDa) passe d'un domaine de profondeur de décharge (DPDDu$_z$) à un autre (DPDDU$_{z+1}$).

9. Procédé selon l'une des revendications 1 à 8, dans lequel, quand un courant (I) est susceptible d'être fourni occasionnellement à la batterie, la pluralité de coefficients de rendement ($K_{x,y}$,$K'_{x,y}$) comprend des coefficients de rendement ($K'_{x,y}$) applicables aux quantités d'électricité ($Q_i$) reçues par la batterie et des coefficients de rendement ($K_{x,y}$) applicables aux quantités d'électricité ($Q_i$) émises par la batterie.

**Patentansprüche**

1. Verfahren zur Bestimmung der Entladetiefe (PDDa) einer Batterie mit zyklischen Schritten, bestehend aus:

   - Berechnen der Entladetiefe (PDDa) der Batterie durch Ermittlung der von der Batterie abgegebenen Elektrizitätsmengen ($Q_i$) und durch Beaufschlagen einer jeglichen Elektrizitätsmenge ($Q_i$) mit einem Leistungskoeffizienten ($K_{x,y}$, $K'_{x,y}$), der ausgewählt ist aus einer Vielzahl von vorab experimentell festgelegten Leistungskoeffizienten ($K_{x,y}$, $K'_{x,y}$),
   - Abschätzen der Entladetiefe (PDDu) der Batterie, ausgehend von einer Messung der Spannung (U) der Batterie und des durch die Batterie fließenden Stromes (I),
   - Vergleichen der berechneten Entladetiefe (PDDa) mit der geschätzten Entladetiefe (PDDu) und wenn der Unterschied zwischen der berechneten Entladetiefe (PDDa) und der geschätzten Entladetiefe (PDDu) größer als ein vorgegebener Schwellwert (SX) ist, Korrigieren wenigstens eines Teils der Leistungskoeffizienten ($K_{x,y}$ $K'_{x,y}$) aus der Vielzahl von Leistungskoeffizienten ($K_{x,y}$, $K'_{x,y}$) derart, dass die berechnete Entladetiefe (PDDa) sich an die geschätzte Entladetiefe (PDDu) annähert, wobei die berechnete Entladetiefe (PDDa) das Verfahrensergebnis ist.

2. Verfahren nach Anspruch 1, dadurch gekennzeichnet, dass die Leistungskoeffizienten ($K_{x,y}$, $K'_{x,y}$) vorab experimentell ausschließlich als Funktion zweier Parameter bestimmt werden, wobei diese Parameter der durch die Batterie fließende Strom (I) und die Entladetiefe (PDDa) der Batterie sind.

3. Verfahren nach einem der Ansprüche 1 bis 2, dadurch gekennzeichnet, dass wenn der Unterschied zwischen der berechneten Entladetiefe (PDDa) und der geschätzten Entladetiefe (PDDu) größer als der vorgegebene Schwellwert (SX) ist, eine Korrektur durchgeführt wird, wenigstens der Leistungskoeffizienten ($K_{x,y}$, $K'_{x,y}$) des Bereichs ($DPDDa_y$) der Entladetiefe (PDDa), in der sich die Batterie befindet, sowie der Leistungskoeffizienten ($K_{x,y+1}$, $K'_{x,y+1}$) des anschließenden Bereichs ($DPDDa_{y+1}$) der Entladetiefe (PDDa) .

4. Verfahren nach einem der Ansprüche 1 bis 3, dadurch gekennzeichnet, dass die Korrektur der Leistungskoeffizienten ($K_{x,j}$, $K'_{x,j}$) einen Schritt umfaßt, der darin besteht, diesem Koeffizienten einen Korrekturterm ($\Gamma$) als Funktion des Unterschiedes zwischen der Entladetiefe (PDDa) und der geschätzten Entladetiefe (PDDu) hinzuzufügen.

5. Verfahren nach Anspruch 4, dadurch gekennzeichnet, dass dieser Korrekturterm (r) wenigstens bestimmt wird durch das Produkt aus:

   - dem Unterschied ($\Delta PDD$) zwischen der gemessenen Entladetiefe (PDDa) und der geschätzten Entladetiefe (PDDu) mit
   - dem Unterschied zwischen den Leistungskoeffizienten ($K_{x,y}$, $K'_{x,y}$), die mit dem Korrekturterm ($\Gamma$) zu beaufschlagen sind und den Leistungskoeffizienten ($K_{x,y,1}$, $K'_{x,y+1}$) des nachfolgenden Bereichs der Entladetiefe ($DPDDa_{y+1}$) .

6. Verfahren nach Anspruch 5, dadurch gekennzeichnet, dass der Korrekturterm ($\Gamma$) außerdem festgelegt ist durch das Produkt aus:

   - dem Unterschied ($\Delta PDD$) zwischen der gemessenen Entladetiefe (PDDa) und der geschätzten Entladetiefe (PDDu) mit
   - dem Abstand zwischen den Leistungskoeffizienten ($K_{x,y+1}$, $K'_{x,y+1}$, $K_{x,y+2}$, $K'_{x,y+2}$) der beiden nachfolgenden Bereiche der Entladetiefe ($DPDDa_{y+1}$, $DPDDa_{y+2}$) .

7. Verfahren nach einem der Ansprüche 1 bis 6, dadurch gekennzeichnet, dass der Vergleich zwischen der berechneten Entladetiefe (PDDa) und der geschätzten Entladetiefe (PDDu) durchgeführt wird, wenn die geschätzte Entladetiefe (PDDu) von einem Bereich der Entladetiefe ($PDDU_z$) zu einem anderen ($DPDDu_{z+1}$) übergeht.

8. Verfahren nach einem der Ansprüche 1 bis 6, dadurch gekennzeichnet, dass der Vergleich zwischen der berechneten Entladetiefe (PDDa) und der geschätzten Entladetiefe (PDDu) durchgeführt wird, wenn die berechnete Entladetiefe (PDDa) von einem Bereich der Entladetiefe ($DPDDu_z$) zu einem anderen ($DPDDu_{z+1}$) übergeht.

9. Verfahren nach einem der Ansprüche 1 bis 8, bei dem, wenn ein Strom (I), der von Zeit zu Zeit der Batterie zugeführt wird, die Vielzahl der Leistungskoeffizienten ($K_{x,y}$, $K'_{x,y}$) Leistungskoeffizienten ($K'_{x,y}$) enthält, die den der Batterie zugeführten Elektrizitätsmengen ($Q_i$) zugeordnet sind, sowie Leistungskoeffizienten ($K_{x,y}$), die den von der Batterie abgegebenen Elektrizitätsmengen ($Q_i$) zugeordnet sind.

## Claims

1. A method for determining the depth of discharge (PDDa) of a battery, comprising cyclical operations consisting in:

   - calculating the depth of discharge (PDDa) of the battery by counting the quantities of electricity ($Q_i$) transmitted by the battery and by applying a performance coefficient ($K_{x,y}$, $K'_{x,y}$) selected from a plurality of experimentally determined performance coefficients ($K_{x,y}$, $K'_{x,y}$) to each quantity of electricity ($Q_i$),
   - estimating the depth of discharge (PDDu) of the battery from a measurement of the battery voltage (U) and the current (I) passing through the battery,
   - comparing the depth of discharge calculated (PDDa) with the depth of discharge estimated (PDDu) and, when the gap between the depth of discharge calculated (PDDa) and the depth of discharge estimated (PDDu) is greater than a predetermined threshold (SX), correcting at least part of the performance coefficients ($K_{x,y}$, $K'_{x,y}$) of the plurality of performance coefficients ($K_{x,y}$, $K'_{x,y}$) such that the depth of discharge calculated (PDDa) tends to become closer to the depth of discharge estimated (PDDu), the depth of discharge calculated (PDDa) constituting the result of the method.

2. A method as claimed in claim 1, characterised in that the performance coefficients ($K_{x,y}$, $K'_{x,y}$) are experimentally predetermined as a function solely of two parameters, these parameters being the current (I) passing through the battery and the depth of discharge (PDDa) of the battery.

3. A method as claimed in one of claims 1 and 2, characterised in that when the gap between the calculated depth of discharge (PDDa) and the estimated depth of discharge (PDDu) is greater than the predetermined threshold (SX), provision is made to correct at least the performance coefficients ($K_{x,y}$, $K'_{x,y}$) of the zone ($DPDDa_y$) of depth of discharge (PDDa) in which the battery is located and the performance coefficients ($K_{x,y+1}$, $K'_{x,y+1}$) of the following zone ($DPDDa_{y+1}$) of depth of discharge (PDDa).

4. A method as claimed in one of claims 1 to 3, characterised in that the correction of the performance coefficients ($K_{x,y}$, $K'_{x,y}$) comprises a stage consisting in adding a correction term ($\Gamma$) that is a function of the gap between the measured depth of discharge (PDDa) and the estimated depth of discharge (PDDu) to these coefficients.

5. A method as claimed in claim 4, characterised in that the correction term ($\Gamma$) is determined at least by the product of:

   - the gap ($\Delta$PDD) between the measured depth of discharge (PDDa) and the estimated depth of discharge (PDDu) and
   - the gap between the performance coefficients ($K_{x,y}$, $K'_{x,y}$) to which the correction term (r) has to be applied and the performance coefficients ($K_{x,y+1}$, $K'_{x,y+1}$) of the following zone of depth of discharge ($DPDDa_{y+1}$).

6. A method as claimed in claim 5, characterised in that the correction term ($\Gamma$) is further determined by the product of:

   - the gap ($\Delta$PDD) between the measured depth of discharge (PDDa) and the estimated depth of discharge (PDDu) and
   - the gap between the performance coefficients (($K_{x,y+1}$, $K'_{x,y+1}$, $K_{x,y+2}$, $K'_{x,y+2}$) of the following two zones of depth of discharge ($DPDDa_{y+1}$, $DPDDa_{y+2}$).

7. A method as claimed in one of claims 1 to 6, characterised in that the comparison between the calculated depth of discharge (PDDa) and the estimated depth of discharge (PDDu) takes place when the estimated depth of discharge (PDDu) moves from one zone of depth of discharge ($DPDDu_z$) to another ($DPDDu_{z+1}$).

8. A method as claimed in one of claims 1 to 6, characterised in that the comparison between the calculated depth of discharge (PDDa) and the estimated depth of discharge (PDDu) takes place when the calculated depth of discharge (PDDa) moves from one zone of depth of discharge $(DPDDu_z)$ to another $(DPDDu_{z+1})$.

9. A method as claimed in one of claims 1 to 8, in which, when a current (I) may be supplied occasionally to the battery, the plurality of performance coefficients $(K_{x,y}, K'_{x,y})$ comprises performance coefficients $(K'_{x,y})$ applicable to the quantities of electricity $(Q_i)$ received by the battery and performance coefficients $(K_{x,y})$ applicable to the quantities of electricity $(Q_i)$ transmitted by the battery.

## FIG.1

**FIG.2**

FIG.3

## FIG.4

Mesure de U,I — 40

Choix de $K_{x,y}$ ou $K'_{x,y}$ — 42

Calcul de $\Delta C_i$ — 44

Calcul de la nouvelle valeur de charge $C_i$ — 46

Calcul de PDDa — 48

Estimation de PDDu — 50

PDDu change de domaine ? — 52

Non ⟶ / Oui ↓

PDDu−PDDa>4% — 54

Non ⟶ / Oui ↓

Calcul des termes correcteurs $\Gamma$ — 56

Calcul des nouveaux coefficients $K^\bullet_{x,y}$ ou $K^{\bullet'}_{x,y}$ — 58

Calcul de $\Delta C^\bullet_i$ corrigée — 60

Calcul de la nouvelle valeur corrigée $C^\bullet_i$ — 62

Calcul de la PDDa — 64

Affichage de la PDDa — 66